# EUROPEAN PATENT APPLICATION

(11) **EP 2 940 257 A1**
(43) Date of publication of application: **04.11.2015**
(21) Application number: 15165278.1
(22) Date of filing: 27.04.2015
(51) Int. Cl.: F01K 25/08, F01K 27/02, H05K 7/20

(54) **SYSTEM AND METHOD FOR INDUCTOR COOLING**

(30) Priority: 30.04.2014 US 201414266341
(71) Applicant: General Electric Company, Schenectady, NY 12345 (US)
(72) Inventor: Myers, Scott Richard, Costa Mesa, CA California 92926 (US); Wang, Quincy Qing, Wellington, FL Florida 33414 (US)
(74) Representative: Cleary, Fidelma

(57) **Abstract**

A system (10) includes a cooling system. The cooling system includes a Rankine cycle (12) and an inductor (34) coupled to the cooling system. The inductor (34) generates heat when in operation. The Rankine cycle (12) circulates a working fluid (26) when in operation, and the working fluid (26) is configured to cool the inductor (34) and to facilitate absorbing heat generated by the inductor (34).

## Description

### BACKGROUND

The subject matter disclosed herein relates generally to power conversion systems and, more particularly, to a system and method for cooling inductors in power conversion systems.

In the power generation industry, high speed generators are used to generate electrical power at relatively high frequencies (typically a number of times higher than the grid frequency), and power converters are used to convert the high frequency alternating current (AC) power down to an AC grid frequency of 50 or 60 Hz. This may be accomplished by rectifying the high frequency AC signal and then generating a new sinusoidal AC wave of the desired frequency. Due to their intrinsic designs, these power converters may typically generate harmonic current distortion. Inductors (e.g., reactors, chokes) installed in series with the drive input and/or the DC bus in the power converter may provide impedance that increases with the frequency of current harmonics, thereby reducing the harmonic current distortion. Unfortunately, due to the winding resistance (e.g., resistance of the winding of the inductors) and/or the core resistance (e.g., losses of the ferromagnetic core of the inductors due to hysteresis loss and eddy current loss), the inductors may generate a substantial amount of heat.

### BRIEF DESCRIPTION

Certain embodiments commensurate in scope with the present disclosure are summarized below. These embodiments are not intended to limit the scope of the claim, but rather these embodiments are intended only to provide a brief summary of the present disclosure. Indeed, embodiments of the present disclosure may encompass a variety of forms that may be similar to or different from the embodiments set forth below.

In a first embodiment, a system includes a cooling system. The cooling system includes a Rankine cycle and an inductor coupled to the cooling system.

In a second embodiment, a method includes circulating a working fluid from an evaporator to an expander, wherein the evaporator is coupled to a heat source and is configured to exchange heat with a hot fluid from the heat source to vaporize the working fluid, and the expander is configured to expand the vaporized working fluid from the evaporator. The method also includes circulating the vaporized working fluid from the expander to a condenser, wherein the condenser is configured to condense the vaporized working fluid from the expander. The method further includes circulating the condensed working fluid from the condenser to a pump, wherein the pump is configured to pressurize the condensed working fluid. The method still includes circulating at least a portion of the pressurized working fluid via a first flow path from the pump to an inductor, wherein the portion of the pressurized working fluid is configured to cool the inductor and produce a heated working fluid, and wherein the heated working fluid maintains a liquid state. The method also includes circulating all of the heated working fluid via a second flow path from the inductor to the evaporator.

In a third embodiment, a system includes a controller. The controller includes one or more tangible, non-transitory, machine-readable media collectively storing one or more sets of instructions. The controller also includes one or more processing devices configured to execute the one or more sets of instructions to monitor or control operations of the system to control a cooling system having a Rankine cycle to cool an inductor of a power generation system.

### BRIEF DESCRIPTION OF THE DRAWINGS

These and other features, aspects, and advantages of the present disclosure will become better understood when the following detailed description is read with reference to the accompanying drawings in which like characters represent like parts throughout the drawings, wherein:
FIG. 1 is a schematic illustration of a power generation system in accordance with the present disclosure;
FIG. 2 is a schematic illustration of an embodiment of a cooling arrangement for an inductor;
FIG. 3 is a schematic illustration of an embodiment of a cooling arrangement for an inductor;
FIG. 4 is a schematic illustration of an embodiment of a cooling arrangement for an inductor;
FIG. 5 is a schematic illustration of an embodiment of a cooling arrangement for an inductor;
FIG. 6 is a schematic illustration of an embodiment of a cooling arrangement for an inductor; and
FIG. 7 is a schematic illustration of an embodiment of a cooling arrangement for an inductor.

### DETAILED DESCRIPTION

One or more specific embodiments of the present disclosure will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," "the," and "said" are intended to mean that there are one or more of the elements. The terms "comprising," "including," and "having" are intended to be inclusive and mean that there may be additional elements other than the listed elements.

As noted above, due to the winding resistance and/or the core resistance of an inductor, the inductor may generate a substantial amount of heat. While cooling fans may be used to cool the inductor, they have various issues, such as not well-adapted to the outdoor environment (e.g., rain, snow, ice, extreme temperatures, insects, or rodents), consuming power generated from the power generation system, not easily implemented, and so forth. The present disclosure provides a method for cooling an inductor in a power generation system, in particular, for cooling an inductor in a heat recovery system that utilizes a heat source to generate electricity via a Rankine cycle, by using cooled working fluid of the Rankine cycle.

A Rankine cycle, as discussed in greater detail below, may include a turbine generator, an evaporator, a condenser, and a liquid pump. The Rankine cycle may circulate a working fluid (e.g., liquid, gas, and/or solid) in a closed loop that may include the above-mentioned components. The Rankine cycle (e.g., an Organic Rankine Cycle) may draw heat from a heat source (e.g., waste heat from engine exhaust) and convert the heat into mechanical work that is further converted by the turbine generator to electricity. In accordance with the present disclosure, using cooled working fluid of the Rankine cycle to cool the inductor may make the inductor more impervious to the outdoor environment because the inductor may be disposed in a closed container, independent of, or integrated with, other power electronics components. In addition, using the existing working fluid to cool the inductor eliminates or substantially decreases use of water as a cooling fluid, therefore, enabling use of the power generation system in more versatile circumstances. Furthermore, the heat dissipated from the inductor is also a type of waste heat, and using the working fluid to cool the inductor involves utilizing the Rankine cycle to convert such heat into electricity as well. This, in effect, converts the inefficiencies of the inductor into the Rankine cycle efficiency. The heat energy from the inductor contributes heat to the Rankine cycle, thereby reducing the heat used by the Rankine cycle from the primary waste heat source.

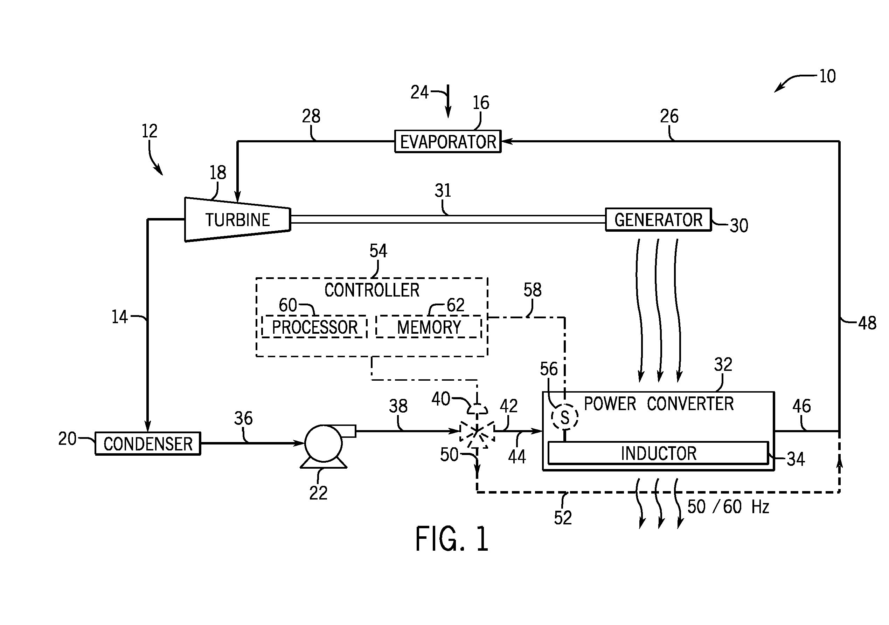

With the foregoing in mind, FIG. 1 illustrates an embodiment of a power generation system 10 in accordance with the present disclosure. The power generation system 10 includes a Rankine cycle 12 (e.g., an Organic Rankine Cycle) having a closed piping loop 14 (e.g., closed working fluid loop, or closed refrigerant loop). The closed piping loop 14 is configured to transport a working fluid (e.g., liquid, gas and/or solid) between components of the Rankine cycle 12, such as an evaporator 16, a turbine 18, a condenser 20, and a pump 22. The working fluid may be a hydrocarbon component (e.g., propane or isobutane), a fluorocarbon (e.g., R-22), an inorganic component (e.g., ammonia or sulfur dioxide), or a hybrid mixture of these components. By way of further example, the working fluid may include R134a, R245fa, cyclohexane, cyclopentane, thiophene, ketones, toluene, aromatics, hexane, propane, butane, pentafluoro-propane, pentafluoro-butane, isobutane, n-pentane, isopentane, isohexane, pentafluoro-polyether, or any combination thereof. The type of working fluid used in the Rankine cycle 12 may be selected based on one or more properties of an external heat source 24, such as temperature, pressure, specific heat, and/or the like. For example, if the temperature of the external heat source 24 is relatively high, certain working fluids with higher evaporation temperatures may be more suitable than others.

As shown, the power generation system 10 may make use of the external heat source 24. The heat source 24 may be any system or process that produces heat, including, but not limited to, geothermal water from a production well, exhaust gas from a gas turbine or a reciprocating engine, waste heat from a reactor (e.g., a gasifier, a partial oxidation unit, and so forth), waste heat from a gas treatment unit (e.g., an acid gas removal unit, a carbon capture unit, and so forth), waste heat from a chemical production unit, waste heat from a gas compressor, a land fill flare, waste heat from an industrial process, or heat from a heated cooling fluid after cooling a process. The external heat source 24 may be directed to the evaporator 16, where the heat from the external heat source 24 may be used to evaporate a working fluid 26 transported into the evaporator 16. The working fluid 26 may be vaporized in the evaporator 16 into a gas 28. The evaporator 16 may be any suitable type for vaporizing the working fluid, including but not limited to, a shell and tube evaporator, a falling or rising film evaporator, a bare tube evaporator, a plate evaporator, a finned evaporator, or any combinations thereof. In some embodiments, the gas 28 may be further heated and/or superheated by a heater (e.g., a boiler) that is independent of, or integrated with, the evaporator 16.

The gas 28 is then transported into an expander, such as the turbine 18, where the gas 28 may expand and cause the turbine 18 to rotate. A load, such as a generator 30, is operatively coupled to the turbine 18 via a shaft 31. The rotation from the shaft 31 produces motive power that may be utilized by the generator 30. The turbine 18 may, for example, be a radial type expander, axial type expander, impulse type expander, high temperature screw type expander, scroll type expander, or positive displacement type expander, or include a parallel or series arrangement of turbines, such as 1, 2, 3, 4, 5, 6, etc. stages of turbines.

The generator 30, in turn, may be operatively coupled to a power converter 32. The power converter 32 may convert the high frequency AC power generated by the generator 30 to lower frequency AC power, such as 50 or 60 Hz, which may be supplied to a grid.

The power converter 32 may include one or more inductors 34. As noted above, the one or more inductors 34 may be installed in series with the drive input and/or the DC bus in the power converter 32 to provide impedance that increases with the frequency of current harmonics, thereby reducing the harmonic current distortion from the power converter 32. As discussed in greater detail below, the one or more inductors 34 may be cooled directly or indirectly by the working fluid 26 in the Rankine cycle 12 in accordance with the present disclosure.

The gas 28, after being expanded by the turbine 18, may then be transported to the condenser 20. The condenser 20 may condense the gas 28 to a liquid state working fluid 36. The condenser 20 may be any suitable type of condenser, including, but not limited to, air-cooled condenser, a plate condenser, a double pipe condenser, a double tube condenser, a shell and coil condenser, a shell and tube condenser, or any combination thereof. This working fluid 36, which is now cooled and in the liquid state, may then be directed into the pump 22. The pump 22 is configured to increase the pressure of the working fluid 36 and to provide a driving force to circulate the working fluid 36 through the components of the Rankine cycle 12.

A pressurized working fluid 38 from the pump 22 may remain in the liquid state. From the pump 22, all of the working fluid 38 flows downstream via one or more flow paths (e.g., a conduit 44 fluidly coupling the pump 22 and the one or more inductors 34) through the one or more (e.g., 1, 2, 3, 4, 5, 6, 7, 8, 9, 10, or more) inductors 34 of the power converter 32. All of the working fluid 38 may be used to cool the one or more inductors 34. After heat exchange with the one or more inductors 34, an output stream 46 of the working fluid 38, while remaining in the liquid state, may be directed along one or more flow paths (e.g., a conduit 48) fluidly coupling the one or more inductors 34 and the evaporator 16. In accordance with the present disclosure, the working fluid 38, when absorbing heat from the one or more inductors 34, is not vaporized. As such, the output stream 46 of the working fluid 38 remains in the liquid state and may be directed to the evaporator 16 without being directed back to upstream of the condenser 20 for re-condensing. Accordingly, the cooling of the one or more inductors 34 may be self-governing in the closed pipe loop 14. For example, when the working fluid (e.g., working fluid 26, 28, 36, 38) circulates faster in the closed pipe loop 14 of the Rankine cycle 12, the generator 30 may generate more power and the one or more inductors 34 may generate more heat, the faster working fluid flow that passes through the one or more inductors 34 may provide more cooling of the one or more inductors 34. Conversely, when the working fluid (e.g., working fluid 26, 28, 36, 38) circulates slower in the closed pipe loop 14 of the Rankine cycle 12, the generator 30 may generate less power and the one or more inductors 34 may generate less heat, the slower working fluid flow that passes through the one or more inductors 34 may provide less cooling of the one or more inductors 34.

In an alternative embodiment in accordance with the present disclosure, a valve (e.g., a control valve 40) and a bypass line (e.g., a conduit 52) may be added to the closed pipe loop 14 to provide further control of the flow of the working fluid 38 that may be used to cool the one or more inductors 34. The control valve 40 and the conduit 52 are illustrated in FIG. 1 with dashed lines to represent elements in the alternative embodiment. As illustrated in FIG. 1, the working fluid 38 may flow from the pump 22 downstream through the control valve 40. The control valve 40 may split the working fluid 38 into two streams. A first stream 42 of the working fluid 38 is directed along one or more flow paths (e.g., the conduit 44) fluidly coupling the control valve 40 and the one or more inductors 34 (e.g., 1, 2, 3, 4, 5, 6, 7, 8, 9, 10, or more) of the power converter 32. The first stream 42 of the working fluid 38 may be used to cool the one or more inductors 34. After heat exchange with the one or more inductors 34, the output stream 46 of the working fluid 38, while remaining in the liquid state, may be directed along one or more flow paths (e.g., the conduit 48) fluidly coupling the one or more inductors 34 and the evaporator 16. Parameters (e.g., flow rate, pressure, or the like) of the first stream 42 of the working fluid 38 may be controlled (e.g., via the control valve 40) such that the first stream 42 of the working fluid 38, when absorbing heat from the one or more inductors 34, is not vaporized. As such, the output stream 46 of the working fluid 38 remains in the liquid state and may be directed to the evaporator 16 without being directed back to upstream of the condenser 20 for re-condensing.

A second stream 50 of the working fluid 38, coming out of the control valve 40, may be directed directly into one or more flow paths (e.g., the conduit 52) that bypass the power converter 32 and the included one or more inductors 34. The second stream 50 of the working fluid 38 may then be combined with the output stream 46 of the working fluid 38, and directed along the conduit 48 to the evaporator 16.

The control valve 40 may be used to control the distribution of the working fluid 38 between the first stream 42 and the second stream 50 (e.g., the respective percentages of the first stream 42 and the second streams 50 with respect to the working fluid 38). For example, the first stream 42 may be approximately 1% to 100% of the working fluid 38. By way of further example, the respective percentages of the first stream 42 and the second stream 50 may be approximately 100% and 0%, 90% and 10%, 80% and 20%, 70% and 30%, 60% and 40%, 50% and 50%, 40% and 60%, 30% and 70%, 20%, and 80%, 10% and 90%, 5% and 95%, 1% and 99% of the working fluid 38. In some embodiments, two control valves, instead of one control valve 40, may be disposed in the conduit 44 and the conduit 52, respectively, to control the distribution of the working fluid 38 between the first stream 42 and the second stream 50. In other embodiments, the power generation system 10 does not include the control valve 40 and all of the working fluid 38 is directed to pass through the one or more inductors 34 of the power converter 32 (e.g., without the second stream 50).

The power generation system 10 may include a controller 54 (e.g., programmable logic controller) that is configured to control the operations of the control valve 40. The controller 54 may be communicatively coupled to the control valve 40 and a sensor 56 coupled to (e.g., located inside, adjacent to, or in flow communication with) the one or more inductors 34. The controller 54 and the sensor 56, similar to the control valve 40 and the bypass conduit 52, are illustrated in FIG. 1 with dashed lines to represent elements of the alternative embodiment. The sensor 56 is configured to measure various parameters associated with the one or more inductors 34, including but not limited to, surface temperature of the one or more inductors 34, temperature of ambient air proximate to the one or more inductors 34, temperature of the working fluid passing the one or more inductors 34, flow rate of the working fluid passing the one or more inductors 34, or any combination thereof. The sensor 56 may send a signal 58 to the controller 54 that is indicative of the condition (e.g., temperature) associated with the one or more inductors 34, and the controller 54 may adjust the control valve 40 accordingly. For example, the controller 54 may adjust the control valve 40 to distribute more (e.g., increase the percentage of) first stream 42 of the working fluid 38 for cooling the one or more inductors 32, if the sensor 56 indicates a temperature of the one or more inductors 34 that is greater than a threshold. Similarly, the controller 54 may adjust the control valve 40 to distribute less (e.g., decrease the percentage of) first stream 42 of the working fluid 38 for cooling the one or more inductors 32, if the sensor 56 indicates a temperature of the one or more inductors 34 less than a threshold.

In some embodiments, the controller 54 may also be used to control the operations of other components of the power generation system 10, such as the evaporator 16, the turbine 18, the condenser 20, the pump 22, the generator 30, or the power converter 32, or any combination thereof. In other embodiments, the power generation system 10 may include two controllers, with one controller (e.g., the controller 54) configured to control the operations of the control valve 40, and the other controller configured to control the operations of the other components of the power generation system 10.

The controller 54 includes various components that may allow for operator interaction with the power generation system 10. The controller 54 may include a distributed control system (DCS) or any computer-based workstation that is fully or partially automated. For example, the controller 54 may be any device employing a general purpose or an application-specific processor 60, both of which may generally include memory circuitry 62 for storing instructions related to pressure differentials and flow rates, for example. The processor 60 may include one or more processing devices, and the memory circuitry 62 may include one or more tangible, non-transitory, machine-readable media collectively storing instructions executable by the processor 60 to perform the methods and control actions described herein.

Such machine-readable media can be any available media other than signals that can be accessed by the processor or by any general purpose or special purpose computer or other machine with a processor. By way of example, such machine-readable media can include RAM, ROM, EPROM, EEPROM, CD-ROM, or other optical disk storage, magnetic disk storage or other magnetic storage devices, or any other medium which can be used to carry or store desired program code in the form of machine-executable instructions or data structures and which can be accessed by the processor or by any general purpose or special purpose computer or other machine with a processor. When information is transferred or provided over a network or another communications connection (either hardwired, wireless, or a combination of hardwired or wireless) to a machine, the machine properly views the connection as a machine-readable medium. Thus, any such connection is properly termed a machine-readable medium. Combinations of the above are also included within the scope of machine-readable media. Machine-executable instructions comprise, for example, instructions and data which cause the processor or any general purpose computer, special purpose computer, or special purpose processing machines to perform a certain function or group of functions.

As noted above, all of the working fluid 38 (including the first stream 42 and the second stream 50) is maintained in the liquid state during the cooling of the one or more inductors 34 in the power converter 32. Suitable working fluid may be selected such that after cooling the one or more inductors 34, the output stream 46 remains in the liquid state. As illustrated, all of the working fluid 38 (including the first stream 42 and the second stream 50) is directed via the conduit 48 to the evaporator 16. Thus, all of the power of pump 22 may be used in the Rankine cycle 12 to produce usable electricity. No additional liquid (e.g., cooled water), and consequently no additional pump for pumping the additional liquid, are used to cool the one or more inductors 34, thereby reducing operating costs associated with the power generation system 10.

In addition, when in operation, as the first stream 42 of the working fluid 38 passes through and cools the one or more inductors 34, the heat dissipated from the one or more inductors 34 may be absorbed by, and therefore heats, the first stream 42 of the working fluid 38. Thus, at least a portion of the working fluid 38 is heated by the one or more inductors 34 before being transported to the evaporator 16 for heating and vaporizing. Accordingly, cooling the one or more inductors 34 with the working fluid 38 reduces the heat used in the Rankine system (e.g., heat used in the evaporator 16 for evaporating the working fluid 26), thereby improving the system efficiency.

Furthermore, as discussed in greater detail below, the present disclosure provides various embodiments of cooling enclosures (e.g., without exposing the one or more inductors 34 to an outdoor environment), thereby enhancing the versatility of the use of the power generation system 10. For example, the effects of outdoor factors, such as rain, snow, ice, extreme temperatures, insects, and rodents, may be decreased or eliminated through use of the disclosed embodiments. Accordingly, the power generation system 10 in accordance with the present disclosure may be certified for outdoor use in a variety of outdoor conditions.

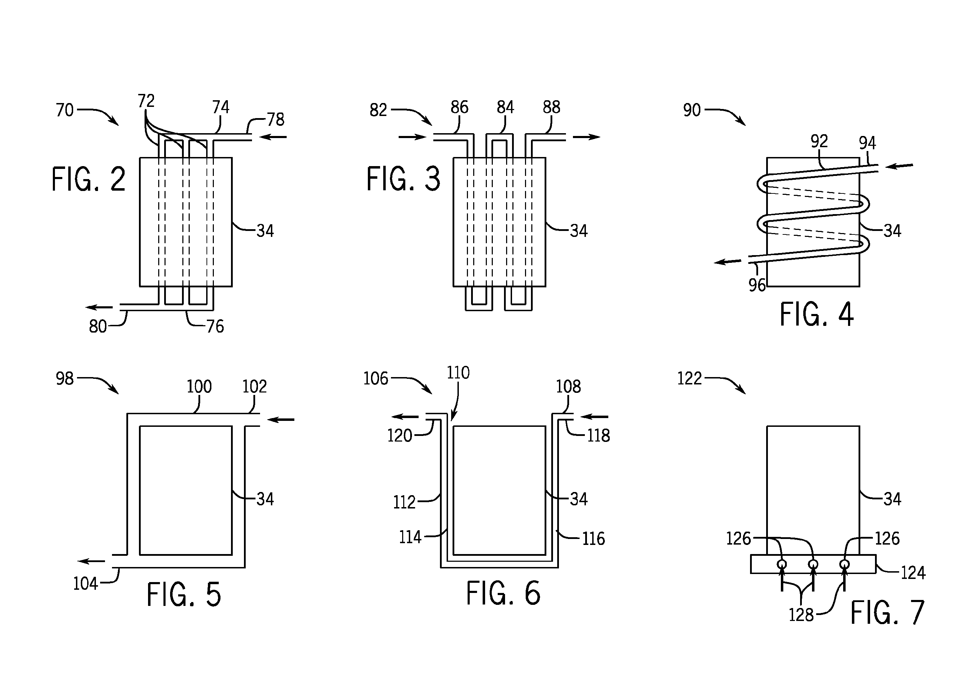

FIGS. 2-7 illustrate various embodiments of a cooling arrangement for cooling the one or more inductors 34 in the power converter 32. However, it should be appreciated that the illustrated embodiments are not exclusive, and any suitable arrangement are contemplated herein. In addition, FIGS. 2-7 illustrate one inductor 34 for simplification, however, it should be appreciated more than one (e.g., 2, 3, 4, 5, 6, 7, 8, 9, 10, or more) inductor 34 may be cooled in similar fashions. In some embodiments, the one or more inductors 34 may be cooled with a combination (e.g., any combination) of the illustrated cooling arrangements, such as a combination of cooling arrangements of FIGS. 2, 3, 4, 5, 6, and 7. For example, the one or more inductors 34 may be cooled with one or more cooling tubes that pass internally through, externally along on external surface, externally along grooves, or any combination thereof.

FIG. 2 illustrates a schematic view of an embodiment of a cooling arrangement 70. The cooling arrangement 70 includes one or more cooling tubes 72 disposed inside of (e.g., passing internally through) the inductor 34. By way of example, the cooling arrangement 70 may include 1, 2, 3, 4, 5, 6, 7, 8, 9, 10, or more, cooling tubes 72. The one or more cooling tubes 72 join together at both ends into manifold tubes 74, 76. The manifold tube 74 has an inlet 78, and the manifold tube 76 has an outlet 80. The inlet 78 is fluidly connected to the conduit 44, and the outlet 80 is fluidly connected to the conduit 48. Thus, the first stream 42 of the working fluid 38 (e.g., liquid and/or gas coolant) may be directed to the inlet 78, flowing through the manifold tube 76, the one or more cooling tubes 72, and the manifold tube 76, and coming out from the outlet 80. When in use, the cool first stream 42 of the working fluid 38 passes through the one or more cooling tubes 72 and exchanges heat with the inductor 34 (e.g., via direct contact with the inductor 34 and/or contact with the heated air inside of the inductor 34).

FIG. 3 illustrates an embodiment of a similar cooling arrangement 82 as the cooling arrangement 70 illustrated in FIG. 2. Instead of joining one or more cooling tubes together (e.g., as illustrated in FIG. 2), the cooling arrangement 82 has one cooling tube 84 passing one or more times, back and forth inside of (e.g., passing internally through) the inductor 34. By way of example, the cooling tube 84 may pass back and forth inside of the inductor 34 1, 2, 3, 4, 5, 6, 7, 8, 9, 10, or more, times. The cooling tube 84 has an inlet 86 and an outlet 88. The inlet 86 is fluidly connected to the conduit 44, and the outlet 88 is fluidly connected to the conduit 48. Thus, the first stream 42 of the working fluid 38 (e.g., liquid and/or gas coolant) may be directed to the inlet 86, flowing through the cooling tube 84, and coming out from the outlet 88. When in use, the cool first stream 42 of the working fluid 38 passes through the cooling tube 84 and exchanges heat with the inductor 34 (e.g., via direct contact with the inductor 34 and/or contact with the heated air inside of the inductor 34).

FIG. 4 illustrates an embodiment of a cooling arrangement 90 with a cooling tube 92 wrapped around the outside of the inductor 34. The cooling tube 92 may be wrapped around the outside of the inductor 34 with one or more turns, such as 1, 2, 3, 4, 5, 6, 7, 8, 9, 10, or more, turns. The cooling tube 92 has an inlet 94 and an outlet 96. The inlet 94 is fluidly connected to the conduit 44, and the outlet 96 is fluidly connected to the conduit 48. Thus, the first stream 42 of the working fluid 38 (e.g., liquid and/or gas coolant) may be directed to the inlet 86, flowing through the cooling tube 92, and coming out from the outlet 96. When in use, the cool first stream 42 of the working fluid 38 passes through the cooling tube 92 and exchanges heat with the inductor 34 (e.g., via direct contact with the inductor 34 and/or contact with the heated air outside of the inductor 34).

FIG. 5 illustrates an embodiment of a cooling arrangement 98 with the inductor 34 at least partially immersed in the working fluid in an enclosure 100 (e.g., a completely sealed or fluid tight enclosure). The enclosure 100 has an inlet 102 and an outlet 104. The inlet 102 is fluidly connected to the conduit 44, and the outlet 104 is fluidly connected to the conduit 48. Thus, the first stream 42 of the working fluid 38 (e.g., liquid and/or gas coolant) may be directed to the inlet 102, flowing through the enclosure 100, and coming out from the outlet 104. When in use, the cool first stream 42 of the working fluid 38 passes through the enclosure 100 and exchanges heat with the inductor 34 (e.g., via direct contact with the inductor 34 and/or contact with the heated air inside and/or outside of the inductor 34). The enclosure 100 helps increase heat transfer by covering entire exterior surface of the inductor 34.

FIG. 6 illustrates an embodiment of a cooling arrangement 106 with the inductor 34 disposed at least partially in a shell 108. The shell 108, as illustrated, forms a partially open container (e.g., with an opening 110). In some embodiments, the shell 108 may form a completely closed container (e.g., without any opening). The shell 108 has two walls, an outer wall 112 and an internal wall 114. A passageway 116 is formed between the outer wall 112 and the internal wall 114. The passageway 116 is configured to flow the first stream 42 of the working fluid 38 (e.g., liquid and/or gas coolant). The passageway 116 has an inlet 118 and an outlet 120. The inlet 118 is fluidly connected to the conduit 44, and the outlet 120 is fluidly connected to the conduit 48. Thus, the first stream 42 of the working fluid 38 may be directed to the inlet 118, flowing through the passageway 116, and coming out from the outlet 120. When in use, the cool first stream 42 of the working fluid 38 passes through the passageway 116 and exchanges heat with the inductor 34 (e.g., via direct contact with the inductor 34 and/or contact with the heated air outside of the inductor 34).

FIG. 7 illustrates an embodiment of a cooling arrangement 122 with the inductor 34 disposed on a cold plate 124. The cold plate 124 has one or more internal openings 126 for passing (e.g., in direction indicated by arrows 128) a working fluid, such as the first stream 42 of the working fluid 38 (e.g., liquid and/or gas coolant), therethrough in order to cool the cold plate 124. The inductor 34 is disposed on the cold plate 124. When in use, the cool first stream 42 of the working fluid 38 passes through the cold plate 124 via the one or more internal openings 126 and exchanges heat with the inductor 34 (e.g., via direct contact with the cold plate 124).

Technical effects of the present disclosure include, but are not limited to, directing at least a portion of the working fluid 38 from the pump 22 to cool the one or more inductors 34 in the power generation system 10 utilizing the Rankine cycle 12. Advantageously, using cooled working fluid 38 (e.g., liquid and/or gas coolant) of the Rankine cycle 12 (e.g., an Organic Rankine Cycle using an organic working fluid) to cool the one or more inductors 34 may make the one or more inductors 34 less prone to the effects of the outdoor environment, thereby increasing the certifiability for outdoor use of the power generation system 10. In addition, using the existing working fluid present in the Rankine cycle 12 to cool the one or more inductors 34 uses no additional water, therefore, providing use of the power generation system 10 in more versatile circumstances. Furthermore, using the working fluid 38 to cool the one or more inductors 34 enables the Rankine cycle 12 to convert the heat (e.g., waste heat) dissipated from the one or more inductors 34 into electricity. This, in effect, converts the inefficiency of the one or more inductors 34 into the efficiency of the Rankine cycle. Moreover, as all of the working fluid 38 is directed via the conduit 48 to the evaporator 16, all of the power of pump 22 may be used in the Rankine cycle 12 to produce usable electricity, thereby increasing the efficiency of, and reducing operating costs associated with, the power generation system 10.

This written description uses examples to disclose the invention, including the best mode, and also to enable any person skilled in the art to practice the invention, including making and using any devices or systems and performing any incorporated methods. The patentable scope of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A system, comprising:
a cooling system (14) comprising a Rankine cycle (12); and
an inductor (34) coupled to the cooling system.

2. The system of claim 1, wherein the Rankine cycle (12) comprises:
an evaporator (16) coupled to a heat source (24) and configured to circulate a working fluid (26) in heat exchange relationship with a hot fluid from the heat source (24) to vaporize the working fluid (26);
an expander (18) coupled to the evaporator (16) and configured to expand the vaporized working fluid (28) from the evaporator (16);
a condenser (20) coupled to the expander (18) and configured to condense the vaporized working fluid (28) from the expander (18); and
a pump (22) coupled to the condenser (20) and configured to pressurize the condensed working fluid (36) to produce a pressurized working fluid (38), and wherein the cooling system comprises:
a first flow path (44) fluidly coupling the pump (22) and the inductor (34) and configured to feed at least a portion of the pressurized working fluid (38) from the pump (22) to the inductor (34), wherein the portion of the pressurized working fluid (38) is configured to cool the inductor (34) and produce a heated working fluid (46) that is maintained in a liquid state; and
a second flow path (48) fluidly coupling the inductor (34) and the evaporator (16) and configured to feed all of the heated working fluid (46) from the inductor (34) to the evaporator (16).

3. The system of claim 2, wherein the first flow path (44) is configured to feed all of the pressurized working fluid (38) from the pump (22) to the inductor (34).

4. The system of claim 2 or 3, wherein the condenser (20) is configured to receive the working fluid only from the expander (18).

5. The system of any of claims 2 to 4, wherein the inductor (34) comprises a tube disposed inside of, or about, the inductor, the tube (72) is configured to transfer the portion of the pressurized working fluid (38) from the pump (22) to the evaporator (16), and the portion (42) of the pressurized working fluid (38) is configured to cool the inductor (34).

6. The system of any of claims 2 to 4, wherein the inductor (34) comprises a shell (108) covering at least a portion of the inductor (34), the shell (108) comprises a passageway (116) between an outer wall (112) of the shell (108) and an inner wall (114) of the shell (108), and the passageway (116) is configured to transfer the portion (42) of the pressurized working fluid (38) from the pump (22) to the evaporator (16), and the portion (42) of the pressurized working fluid (38) is configured to cool the inductor (34).

7. The system of any of claims 2 to 4, wherein the inductor (34) is disposed on a cold plate (124) having a plurality of openings (126) formed therein, the cold plate (124) is configured to transfer the portion (42) of the pressurized working fluid (38) via the plurality of openings (126) from the pump (22) to the evaporator (16), and the portion (42) of the pressurized working fluid (38) is configured to cool the inductor (34).

8. A method, comprising:
circulating a working fluid (26) from an evaporator (16) to an expander (18), wherein the evaporator (16) is coupled to a heat source (24) and is configured to exchange heat with a hot fluid from the heat source (24) to vaporize the working fluid (26), and the expander (18) is configured to expand the vaporized working fluid (28) from the evaporator (16);
circulating the vaporized working fluid (28) from the expander (18) to a condenser (20), wherein the condenser is configured to condense the vaporized working fluid (28) from the expander (18);
circulating the condensed working fluid (36) from the condenser (20) to a pump (22), wherein the pump (22) is configured to pressurize the condensed working fluid (36);
circulating at least a portion (42) of the pressurized working fluid (38) via a first flow path from the pump (22) to an inductor (34), wherein the portion of the pressurized working fluid is configured to cool the inductor (34) and produce a heated working fluid (46), and wherein the heated working fluid (46) maintains a liquid state; and
circulating all of the heated working fluid (46) via a second flow path from the inductor (34) to the evaporator (16).

9. The method of claim 8 comprising circulating all of the pressurized working fluid (38) via the first flow path from the pump (22) to the inductor (34).

10. The method of claim 8 or 9, comprising directing via a valve (40) at least a portion (42) of the pressurized working fluid (38) from the pump (22) directly to the evaporator (16).

11. The method of claim 8 or 9, comprising transferring the portion (42) of the pressurized working fluid (38) via a tube (72,84) disposed inside of, or about, the inductor (34) from the pump (22) to the evaporator (16) to cool the inductor (34).

12. The method of claim 8 or 9, comprising transferring the portion (42) of the pressurized working fluid (38) via a shell (108) from the pump (22) to the evaporator (111) to cool the inductor (34), wherein the shell (108) covers at least a portion of the inductor (34) and comprises a passageway (116) between an outer wall (112) of the shell (108) and an inner wall (114) of the shell (108).

13. The method of claim 8 or 9, comprising transferring the portion (42) of the pressurized working fluid (38) via a plurality of openings (126) of a cold plate (124) from the pump (22) to the evaporator (16) to cool the inductor (34), wherein the inductor (34) is disposed on the cold plate (124).

14. A computer program comprising computer program code means adapted to perform the steps of the method of any of claims 8 to 13 when executed by a computer processing device.

15. A system, comprising:
a controller (54), comprising:
one or more tangible, non-transitory, machine-readable media collectively storing the computer program of claim 14; and
one or more processing devices configured to execute the computer program code to monitor or control operations of the system to control a cooling system having a Rankine cycle (12) to cool an inductor (34) of a power generation system.
